# EUROPEAN PATENT APPLICATION

(11) **EP 4 760 777 A1**
(43) Date of publication of application: **17.06.2026**
(21) Application number: 24220202.6
(22) Date of filing: 16.12.2024
(51) Int. Cl.: H01L 21/67

(54) **DIE SUPPLIER**

(71) Applicant: ASML Netherlands B.V., 5500 AH Veldhoven (NL)
(72) Inventor: Seijger, Olav, Johannes, 5500 AH Veldhoven (NL)
(74) Representative: ASML Netherlands B.V.

(57) **Abstract**

A die supplier comprises: a donor support configured to support a donor substrate that supports a plurality of dies; and a transfer arm configured to transfer dies from the donor substrate; wherein the donor support is configured to rotate the donor substrate.

## Description

### TECHNICAL FIELD

The present disclosure relates generally to a die supplier, a bonding tool, and a method for supplying dies and a method of bonding.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die - where these specific portions which may be aligned in three-dimensional space to ensure functional connectivity. Alignment of these die, which may have multiple fabrication layers, different critical dimensions, different nodes, packaging, etc., with each other may require different techniques than used for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another.

In the context of semiconductor manufacture, improvements in a bonding process (e.g., improvements in heterogeneous integration) lead to improvements in IC manufacturing and integration abilities. In a bonding process, dies or substrates are to be transferred from a donor substrate onto a stage or acceptor substrate. In order to pick dies off a donor substrate, a gantry may be used. The gantry is required to have at least the diameter of the donor substrate in two orthogonal directions. A large stroke may be undesirable because large accelerations are required in order to increase or maintain the frequency of transferring dies from the donor substrate. It is desirable to reduce the stroke of an apparatus or transferring dies from a donor substrate.

### SUMMARY

According to an embodiment, there is provided a die supplier comprising:
a donor support configured to support a donor substrate that supports a plurality of dies; and
a transfer arm configured to transfer dies from the donor substrate;
wherein the donor support is configured to rotate the donor substrate.

According to an embodiment, there is provided a method for supplying dies comprising:
supporting, with a donor support, a donor substrate that supports a plurality of dies; and
transferring, with a transfer arm, dies from the donor substrate;
wherein the donor support rotates the donor substrate.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figure 2 is a schematic diagram illustrating a method of placement of dies by a moveable stage with recesses, according to an embodiment.
Figure 3 schematically depicts a die supplier.
Figure 4 is a plan view of a donor substrate at a first rotational position.
Figure 5 is a plan view of the donor substrate at a second rotational position.
Figure 6 is a schematic depiction of the donor substrate at a third rotational position.
Figure 7 is a plan view of the die supplier shown in Figure 3.
Figure 8 is a plan view of an alternative die supplier.
Figure 9 is a perspective view of an alternative die supplier.
Figure 10 is a plan view of the die supplier shown in Figure 9.
Figure 11 is a plan view of an alternative die supplier.
Figure 12 is a cross-sectional view of the die supplier shown in Figure 3 or Figure 7, for example.
Figure 13 is a perspective view of an edge sensor for a die supplier.
Figure 14 is a perspective view of a camera for a die supplier.
Figure 15 schematically depicts a vision system for a die supplier.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

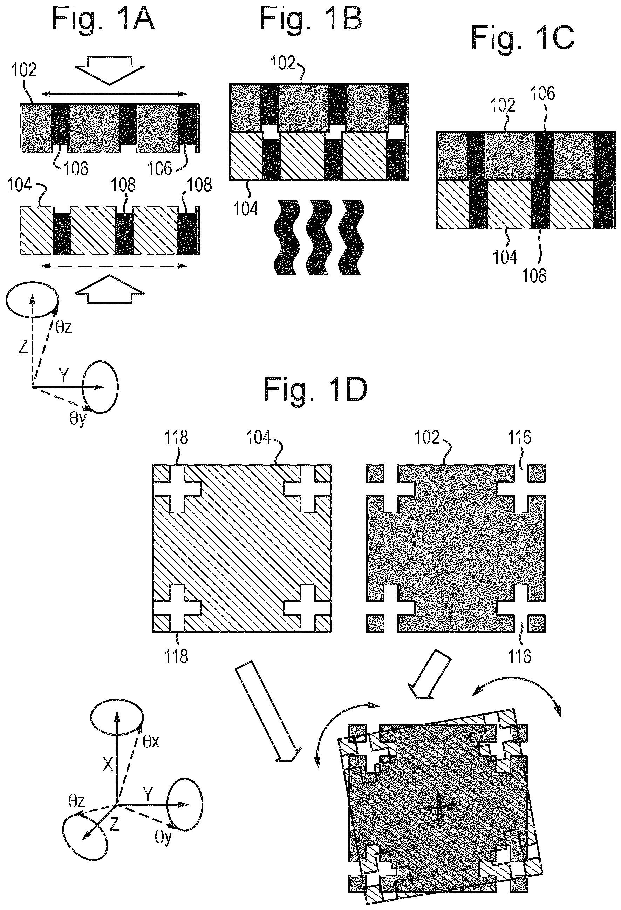

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1 A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1A, the donor die 102 and the target die 104 may be brought together along the z-axis, while the position of the donor die 102 or the target die 104 may be adjusted in the x-y plane (e.g., perpendicular to the z-axis of approach). As shown in Figure 1B, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure 1D, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non- zero linewidth portion of the wafer volume when separating die. Alternatively, the electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

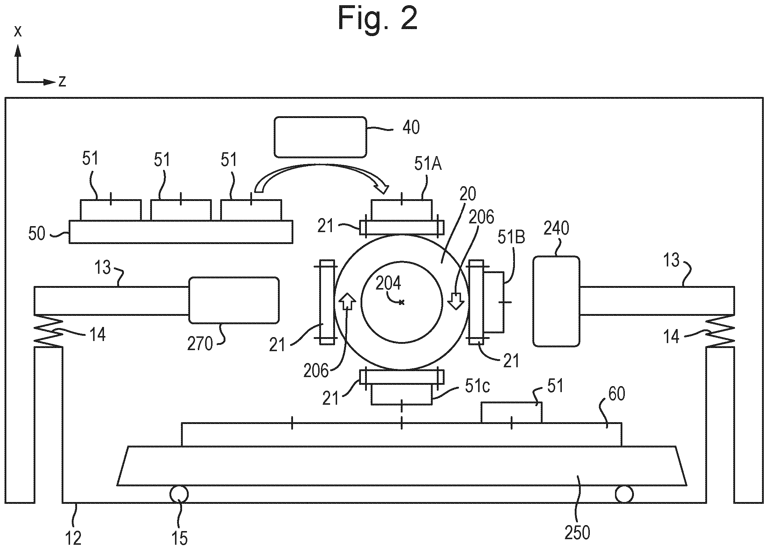

Figure 2 is a schematic diagram illustrating a method of placement of donor dies by a moveable stage with recesses. Figure 2 is described with reference to "donor die" and "target die", which are relative descriptors and donor die may instead be target die and vice versa. Figure 2 is a cross-sectional view of placement of donor die 51A-210D using support stage 20. The support stage 20 is substantially circular in the x-z plane, with a longitudinal axis 204 along the y-direction (e.g., the support stage 20 is substantially cylindrical in three dimensions). The support stage 20 may instead have a different cross-sectional shape, such as square, hexagonal, etc. The support stage 20 may have a symmetrical (e.g., as shown) cross-section with one or more axis of symmetry, or asymmetrical cross-sectional area (for example, an irregular polygon).

The support stage 20 has die acceptors 21. The placement of the die acceptors 21 may be symmetrical or asymmetrical around the cross-sectional area of the support stage 20. The support stage 20 may have a substantially symmetrical cross section but have asymmetric placement of recesses. For example, the support stage 20 may have a cross-section that is a regular hexagon but have recesses placed asymmetrically along longitudinal faces. The die acceptors 21 are capable of accepting donor dies, such as the donor dies 51.

The support stage 20 may be controllably moved in a direction 206 about the longitudinal axis 204. The direction 206 is provided as an example. The support stage 20 may instead be rotated in an opposite direction or any appropriate direction, translated along the x, y, or z direction or any combination thereof. The support stage 20 may be operated in both rotational and a translational modes, including sequentially or at the same time. For example, the support stage 20 may move in the negative x-direction towards a support structure 250 while also rotating about the longitudinal axis 204. The support stage 20 may move continuously or intermittently. For example, the support stage 20 may rotate in the direction 206 and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the support stage 20 is substantially zero), but the positions may instead correspond to continuous (or quasi-continuous movement) or operations may occur while the support stage 20 is moving in one or more directions (e.g., rotationally, translationally, etc.).

A first position, such as corresponding to the position depicted for the donor die 51A, may correspond to placement of die in die acceptors 21 of the support stage 20. The donor die 51A may be placed on the die acceptor 21 by a transfer arm 40. The transfer arm 40 may place the donor die 51A on the support stage 20 on the die acceptor 21 based on alignment information, based on positional information of the support stage 20, etc. The transfer arm 40 may place the donor die 51A on the support structure at a given position relative to the die acceptor 21. For example, the transfer arm 40 may center the donor die 51A relative to the die acceptor 21. The transfer arm 40 may have intrinsic error or inaccuracy.

The second position, such as corresponding to the position depicted for the donor die 51B, may correspond to measurement of the position of the die in recesses (e.g., of the donor die 51B relative to the die acceptor 21) of the support stage 20. The position (e.g., location) of the donor die S 1B may be measured by a location measurement element 240. The location measurement element 240 may measure an actual position of the donor die S1B, in relative (such as relative to the die acceptor 21) or absolute terms (such as in distances from an origin point on the support stage 20, on the location measurement element 240, etc.). The location measurement element 240 may be a camera, e.g., a two-dimensional camera, two or more one-dimensional cameras, an optical camera, etc., or another measurement device. The location measurement element 240 may be made up of multiple location measurement elements, such as an inplane measurement device which may measure locations in the y-z plane (relative to the refence axes) and an out of plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the support stage 20.

Once the position of the donor die 51B is measured, the support stage 20 may move (e.g., in the direction 206), so that the donor die 51B occupies the position of the donor die 51C which may be a third position of the support stage 20. The third position of the support structure will now be described with reference to the donor die 51C.

The third position, such as corresponding to the position depicted for the donor die 51C, may correspond to placement of the die on a corresponding target, for example, an acceptor substrate 60?. The acceptor substrate 60 may comprise one or more target dies which may be sequentially contacted by a donor die during various movements of the support stage 20.

The acceptor substrate 60 is supported by the support structure 250. The donor die 51C may be placed on the acceptor substrate 60 by motion of the support stage 20 towards the acceptor substrate 60. Alternatively or additionally, the support structure 250 may also be a moveable structure operable to bring the donor die 51C and the acceptor substrate 60 into contact.

Once the donor die 51C is placed on the acceptor substrate 60, the support stage 20 and the support structure 250 may operate (individually or in concert) to place additional donor dies on the acceptor substrate 60. For example, the support structure 250 may move in the negative z-direction so that another part of the acceptor substrate 60 is proximate to the support stage 20 and a donor die (for example, the donor die 51B after rotation of the support stage 20) may be placed on the acceptor substrate 60. The relative motion of the support stage 20 and the support structure 250 may occur in any appropriate direction. A direction of gravity is not depicted, but the placement of the donor die 51C on the acceptor substrate 60 may experience gravitation effects. For example, the placement of the donor die 51C on the acceptor substrate 60 may be encouraged by gravity (e.g., occur in the direction of gravity) or be retarded by gravity (e.g., occur opposite the direction of gravity). Gravitational effects may be balanced by die clamps, suction, vacuum, and other forces.

The stage 20 shown in Figure 2 is for die placement. The stage 20 is for placing dies 51, for example onto an acceptor substrate 60. The stage 20 comprises an actuator. The actuator is configured to cause the stage 20 to accept the dies 51 from the transfer arm 40 and subsequently transport the dies 51 to alignment sensor 240 and finally place the dies 51 on the acceptor substrate 60.

In an embodiment the stage 20 comprises an actuator. The actuator may be a Lorentz force actuator. Alternatively a different type of actuator may be used. The actuator is configured to apply forces to cause the stage 20 to move at least one die 51, for example for placement of the die 51.

In an embodiment the stage 20 a movable member configured to hold at least one die 51. For example, as shown in Figure 2 in an embodiment the movable member is configured to hold four dies 51. The movable member may comprise at least one die acceptor 21. As shown in Figure 2, in an embodiment the movable member comprises a plurality of die acceptors 21, for example at least four die acceptors 21. Each die acceptor 21 may be configured to hold a die 51. The die acceptors 21 may be provided at an outward facing surface of the movable member of the stage.

In an embodiment, the actuator is configured, on actuation, to move the movable member of the stage 20. In an embodiment the actuator is configured, on actuation, to move the movable member in six degrees of freedom. The six degrees of freedom may be movement in the X direction (i.e. the vertical direction shown in Figure 2), movement in the Z direction (i.e. the horizontal direction shown in Figure 2), movement in the Y direction (i.e. into and out of the plane of Figure 2), rotation about the Y axis, tilt about the X axis and tilt about the Z axis.

The actuator is configured to move the movable member at high accuracy. High accuracy is required for placing the dies 51 onto the acceptor substrate 60.

As shown in Figure 2, in an embodiment the acceptor substrate 60 is supported by a support structure 250. In an embodiment the support structure 250 is configured to move the acceptor substrate 60 at high accuracy. In an embodiment, a controller is configured to control the stage 20 and the support structure 250 so as to accurately place the die 51 from the donor substrate 50 to the acceptor substrate 60.

The actuator is configured, on actuation, to move the movable member of the stage 20 with substantially zero friction. An embodiment of the invention is expected to achieve high accuracy of die placement.

Figure 2 schematically depicts a bonding tool for bonding a die 51 to an acceptor substrate 60. The bonding tool comprises the stage 20 for die placement.

As shown in Figure 2, in an embodiment the bonding tool comprises a base frame 12. As shown in Figure 2, in an embodiment the support structure 250 that supports the acceptor substrate 60 is coupled to the base frame 12 by at least one bearing 15. In an embodiment the support structure 250 comprises a plurality of stages that may be stacked relative to each other via a plurality of bearings. For example, the support structure 250 may comprise a long stroke module for relatively coarse positioning of the acceptor substrate 60 over a longer distance, and a short stroke module for higher accuracy positioning of the acceptor substrate 60 over a shorter stroke. The short stroke module may be stacked on the long stroke module.

As shown in Figure 2, in an embodiment the bonding tool comprises a metrology frame 13. The metrology frame 13 may be referred to as an isolated frame. The metrology frame 13 may be isolated relative to the base frame 12.

For example, as shown in Figure 2, in an embodiment the bonding tool comprises an isolator 14. The isolator 14 is configured to substantially isolate the metrology frame 13 from the base frame 12. By isolating the metrology frame 13 from the base frame 12, vibrations of the base frame 12 may have less effect on the metrology frame 13.

For example, in an embodiment measurements of the location of a die 51 may be made relative to the metrology frame 13. An embodiment of the invention is expected to achieve high accuracy of positioning of a die 51.

In an embodiment part of the stage 20 is secured to the base frame 12. For example, a support of the stage 20 may be fixed to the base frame 12. In an embodiment, the position of the movable member of the stage 20 is measured and controlled with respect to the metrology frame 13.

An embodiment of the invention is expected to have relatively low sensitivity of the stage 20 for external vibrations. This can help to achieve high position accuracy of the stage 20, and therefore the at least one die 51 to be placed.

An embodiment of the invention is expected to achieve high internal eigenfrequencies of the stage 20. Such high internal eigenfrequencies are expected to allow a high control bandwidth to be realised. This is expected to result in high position accuracy of the stage 20.

Embodiments of the invention are primarily described with reference to embodiments in which the stage 20 is generally wheel shaped. Unless specific reference is made to the geometry of the stage 20, it is to be understood that such a wheel shape is not required.

As shown in Figure 2, in an embodiment the bonding tool comprises at least one location measurement element 240, which may be referred to as an alignment sensor. As shown in Figure 2, the location measurement element 240 may be secured to the metrology frame 13. As shown in Figure 2, in an embodiment the bonding tool comprises an acceptor exchange element 270. The acceptor exchange element 270 may be secured to the metrology frame 13 or to the base frame 12. The acceptor exchange element 270 is configured to exchange a die acceptor 21 of the stage 20 for a replacement die acceptor. Alternatively, the nozzle exchange element 270 may be omitted.

As shown in Figure 2, in an embodiment the bonding tool comprises the transfer arm 40. The transfer arm 40 may be referred to as a pick and place robot.

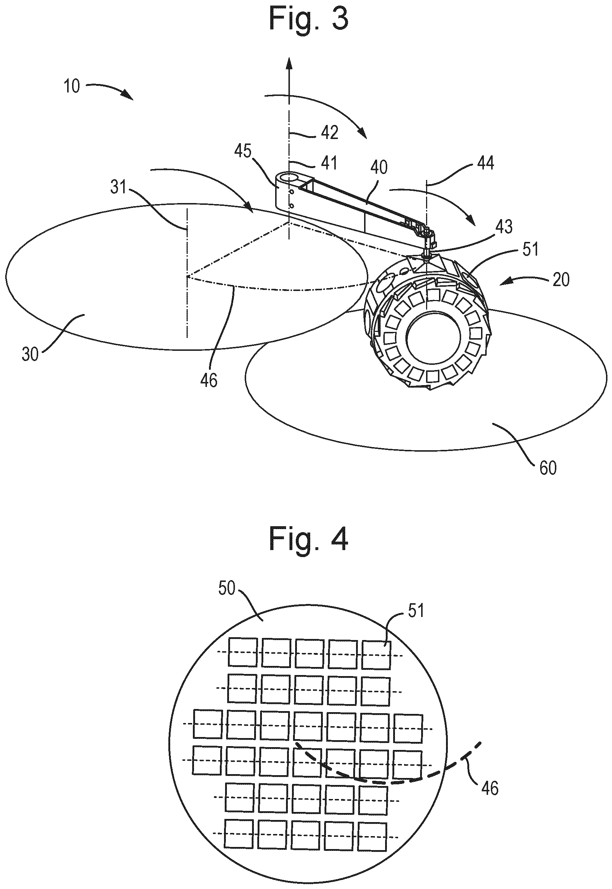

Figure 3 schematically depicts a die supplier 10. The die supplier may be for a bonding tool, for example of the type shown in Figure 2. In an embodiment the die supplier is configured to supply dies from a donor substrate 50 to a stage 20 or to an acceptor substrate 60, for example.

In the arrangement shown in Figure 3, the die supplier 10 is configured to supply dies 51 to the stage 20. The stage 20 is configured to transfer the dies 51 to the acceptor substrate 60. The stage 20 and the acceptor substrate 60 shown in Figure 3 are merely exemplary. The die supplier 10 may be used in the context of a different type of stage and a differently oriented acceptor substrate 60. Features of the die supplier 10 do not depend on the stage 20 having the features of the stage 20 as shown in Figure 3 and described in this document.

As shown in Figure 3, in an embodiment the stage 20 is configured to rotate. By rotating the stage 20, a die 51 that is placed on the top of the stage 20 is flipped during the process of moving the die 51 onto the acceptor substrate 60. It is not essential for a rotating stage to be provided in order to flip the dies 51. For example, in an alternative embodiment the stage may be formed as a flipper or a vertical transfer arm. The die supplier is described primarily in the context of use with a rotating stage 20, although the use of the die supplier 10 is not limited to use with a rotating stage 20.

As shown in Figure 3, in an embodiment the donor substrate 50 and the acceptor substrate 60 may be provided at different vertical positions. The donor substrate 50 may be located higher than the acceptor substrate 60. As shown in Figure 3, the donor substrate 50 may be offset horizontally from the acceptor substrate 60. As shown in Figure 3, the donor substrate 50 and the acceptor substrate 60 may overlap partly in plan view.

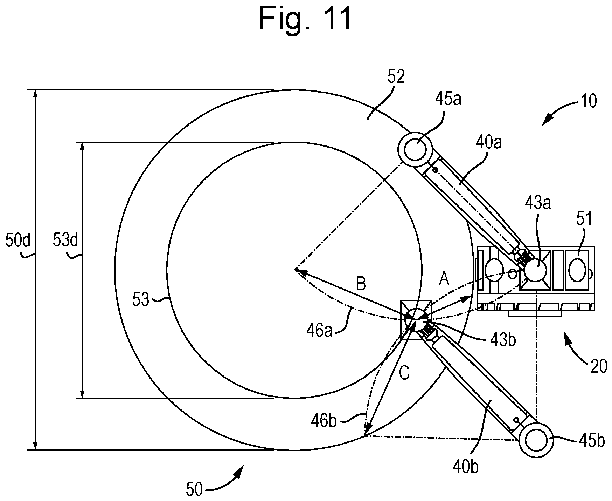

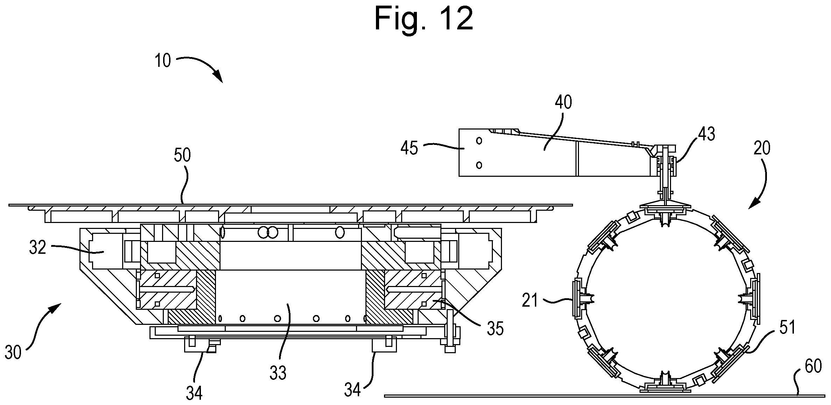

As shown in Figure 3, in an embodiment the die supplier 10 comprises a donor support 30. The donor support 30 is configured to support a donor substrate 50 (see Figure 11 or Figure 12, for example). For example, the donor support 30 may be configured to hold the donor substrate 50. The donor substrate 50 may be supported at an upper surface of the donor support 30.

Although not shown in the drawings, in an embodiment the donor support 30 comprises a plurality of burls for supporting a lower surface of the donor substrate 50. In an embodiment the burls have distal ends arranged in a plane for supporting the lower surface of the donor substrate 50 at the plane. By providing a plurality of burls, the flatness of the supported donor substrate 50 may be improved.

In an embodiment the donor support 30 is configured to clamp the donor substrate 50 onto the donor support 30. The donor support 30 may be configured to apply a clamping force for clamping the donor substrate 50 onto the donor support 30. In an embodiment the clamping force is a vacuum clamping force. The donor support 30 may be configured such that a gap between the lower surface of the donor substrate 50 and a base surface (from which the burls protrude) of the donor support 30 is in fluid communication with an under pressure. The under pressure helps to clamp the donor substrate 50 onto the donor support 30.

Additionally or alternatively the clamping force may comprise an electrostatic force. In an embodiment the donor support 30 comprises one or more electrodes. The donor support is configured to control the electric potential of the one or more electrodes to control electrostatic clamping of the donor substrate 50 onto the donor support 30.

Figure 4 is a schematic plan view of the donor substrate 50. As shown in Figure 4, in an embodiment the donor substrate is substantially circular. Alternative shapes of substrate may be used.

As shown in Figure 4, in an embodiment the donor substrate 50 is configured to support a plurality of dies 51. In an embodiment the dies 51 are arranged in a pattern on the donor substrate 50. The pattern may be a regular pattern. For example, as shown in Figure 4 in an embodiment the dies 51 are arranged in a grid. The grid may be a rectilinear grid.

Figure 4 is only schematic. The number of dies 51 shown as being supported on the donor substrate 50 in Figure 4 is only exemplary. In an embodiment, the number of dies 51 may be far greater than is shown in Figure 4. The pattern, for example, the grid shown in Figure 4 may be modified.

As shown in Figure 3, in an embodiment the die supplier 10 comprises a transfer arm 40. The transfer arm 40 is configured to transfer dies 51 from the donor substrate 50. The donor substrate 50 is supported on the donor support 30. The transfer arm 40 can reach to one or more locations of the donor substrate 50 so as to engage with dies 51 supported by the donor substrate 50. The transfer arm 40 is configured to be able to reach one or more locations beyond the donor substrate 50 so as to transfer the collective dies away from the donor substrate 50 (i.e. to a location separate from the donor substrate 50). In an embodiment the transfer arm 40 is configured such that within its stroke are provided at least part of the donor substrate 50 and at least part of an area beyond the donor substrate 50.

In an embodiment, the donor support 30 is configured to rotate the donor substrate 50. Figure 3 schematically depicts the rotational axis 31 of the donor support 30. In an embodiment the donor support 30 is configured to rotate the donor substrate 50 about the rotational axis 31. In an embodiment the donor substrate 50 is located on the donor support 30 such that the centre of the donor substrate 50 substantially coincides with the rotational axis 31 of the donor support 30. Of course there may be some offset between the centre of the donor substrate 50 and the rotational axis 31 of the donor support 30. Figure 3 schematically depicts the rotation by the presence of a curved arrow above the rotational axis 31.

In an embodiment the donor support 30 is configured to rotate the donor substrate 50 at least one full rotation. The rotational axis 31 may be for 360° motion of the donor substrate 50.

By providing that the donor support 30 is configured to rotate the donor substrate 50, the required stroke of the transfer arm 40 may be reduced. As a comparative example, if the donor substrate 50 were not rotated, then the transfer arm 40 would be required to reach across the full diameter of the donor substrate 50 in order to be able to transfer all of the dies 51 off the donor substrate 50. By providing that the donor substrate 50 is rotated during use, the transfer arm 40 is required to be able to reach only the centre point of the donor substrate 50. Dies 51 that are initially beyond the reach of the transfer arm 40 come into the reach of the transfer arm 40 as the donor substrate 50 is rotated by the donor support 30. An embodiment of the invention is expected to reduce the required stroke of the transfer arm 40.

In addition to reducing the maximum required stroke of the transfer arm 40, an embodiment of the invention is expected to reduce the overall stroke used by the transfer arm 40 during a transfer operation. In a transfer operation, a plurality of dies 51 at different locations on the donor substrate 40 may be transferred off the donor substrate 50. By rotating the donor support 30 during the transfer operation, the actual stroke (i.e. overall amount moved by) the transfer arm 40 may be reduced compared to if the donor substrate 50 were stationary throughout the transfer operation. By reducing the actual stroke used, the embodiment of the invention is expected to increase the frequency of transferring dies 51 from the donor substrate 50. An embodiment of the invention is expected to increase throughput of dies 51 being transferred from a donor substrate 50 to supply the dies (e.g. for a bonding process).

An embodiment of the invention is expected to reduce the footprint of the die supplier 10. By reducing the maximum stroke required of the transfer arm 40, the space required to be dedicated to horizontal movements of the transfer arm 40 may be reduced. This may allow more space for other components within a larger system, such as a bonding tool.

In an embodiment the die supplier 10 comprises a controller configured to control at least one of rotation of the donor support 30 and movement of the transfer arm 40. Therefore, the controller may output control signals to the donor support 30 so as to control movement of the donor support 30. The controller may be configured to control a speed of rotation of the donor support 30 and/or a target rotational position of the support 30. The controller may be configured to receive signals the data signals may comprise information about positions of dies 51 on the donor substrate 50 the rotational position of the donor substrate 50 of the position of the transfer arm 40 and/or the position of the stage 20, for example. In an embodiment the controller is configured to control at least one of rotation of the donor support 30 and movement of the transfer arm 40 dependent on the data signals received by the controller.

Figure 3 schematically depicts a stroke 46 of the arm 40. The stroke 46 shown in Figure 3 may represent the maximum of movement of the transfer arm 40 during use of the supplier 10. As shown in Figure 3, in an embodiment the transfer arm 40 has a maximum lateral stroke less than or equal to a lateral dimension of the donor substrate 50. The lateral dimension of the donor substrate 50 may be the diameter of the donor substrate 50. The lateral dimension of the donor substrate 50 may be less than or equal to the lateral dimension of the supporting surface of the donor support 30. An embodiment of the invention is expected to reduce a footprint of the die supplier 10. An embodiment of the invention is expected to increase throughput. However, it is not essential for the transfer arm 40 to have its maximum stroke limited to be less than or equal to the lateral dimension of the donor substrate 50. In an alternative embodiment, the transfer arm 40 has a maximum stroke greater than the lateral dimension of the donor substrate 50. In use of the die supplier 10, the actual stroke of the transfer arm 40 that is used may be limited so as to increase throughput, for example.

As shown in Figure 3, in an embodiment the transfer arm 40 has a lateral dimension less than or equal to a lateral dimension of the donor substrate 50. In an embodiment the transfer arm 40 has a lateral dimension less than or equal to half the lateral dimension of the donor substrate 50. By reducing the lateral dimension of the transfer arm 40, the footprint of the die supplier 10 may be reduced. This may allow more space for other components of a larger system.

However, it is not essential for the transfer arm 40 to be smaller than the diameter of the donor substrate 50. In an alternative embodiment, the transfer arm 40 has a lateral dimension greater than the lateral dimension of the donor substrate 50. By increasing the lateral dimension of the transfer arm 40, the angular rotation of the transfer arm 40 required in order to reach between the centre of the donor substrate 50 and the stage 20 may be reduced.

As shown in Figure 3, in an embodiment the transfer arm 40 is configured to rotate about a transfer axis 41. The transfer axis 41 may be a rotational axis. For example, the transfer axis 41 may be a rotational axis for back and forth motion of the transfer arm 40. The transfer arm 40 may rotate back and forth between locations on the donor substrate 50 and the stage 20. In an embodiment the transfer arm 40 is configured to rotate to different positions for picking up respective dies 51 from the donor substrate 50. The rotational position at which the transfer arm 40 picks up the die 51 may depend on the location of the die 51 on the donor substrate 50 and the rotational position of the donor substrate 50. In an embodiment the transfer arm 40 is configured to repeatedly rotate to substantially a similar position for depositing the picked up dies 51 onto the stage 20.

By providing that the transfer arm 40 is configured to rotate, translational movements of the transfer arm 40 may be reduced. By reducing translational movements, the moving mass may be reduced and/or reaction forces may be reduced. An embodiment of the invention is expected to allow more straightforward balance masses to balance out reaction forces caused by movements.

An embodiment of the invention is expected to reduce particle generation during use of the die supplier 10. By providing that the transfer arm 40 is configured to rotate, it may be easier to prevent particles being created and entering into the ambient atmosphere of the bonding tool. For example, in an embodiment the transfer arm 40 comprises a pivot 45 for pivoting around the transfer axis 41. In an embodiment the transfer arm 40 comprises two bushes connected with an under pressure so as to reduce the possibility of particles escaping while allowing rotation of the transfer arm 40 about the pivot 45.

However, it is not essential for the transfer arm 40 to be configured to rotate about a transfer axis 41. In an alternative embodiment, the transfer arm 40 may be configured to move translationally. For example, the transfer arm 40 may comprise a gantry for performing translational movements in two or more directions.

As shown in Figure 3, in an embodiment the transfer arm 40 has a maximum rotational stroke of at most 180°, and optionally at most 90°. In the arrangement shown in Figure 3, the maximum rotational stroke is about 90°. By reducing the rotational stroke needed, the dies 51 may be transferred more quickly. An embodiment of the invention is expected to increase throughput.

However, it is not essential for the transfer arm 40 to have a maximum rotational stroke of at most 180°. In an alternative embodiment, the transfer arm 40 has a maximum rotational stroke greater than 180°. In an embodiment, the controller is configured to control rotation of the transfer arm 40 to be less than its maximum rotational stroke. For example, the controller may be configured to limit the maximum rotational stroke of the transfer arm 40 so as to increase throughput. In an alternative embodiment, the controller may be configured to rotate the transfer arm 40 along a rotational stroke of greater than 180° so as to increase the number of different locations from which the transfer arm 40 can pick up dies 51 from the donor substrate 50. As shown in Figure 3, in an embodiment the transfer arm 40 comprises an engagement member 43. In an embodiment the engagement member 43 is configured to engage with a die 51. For example, the engagement member 43 may be configured to engage with a die 51 so as to transfer the die 51 from the donor substrate 50. In an embodiment the engagement member comprises a die clamp (e.g. a pipette or a collet). In an embodiment the poppet is configured to provide an under pressure for vacuum clamping a die 51 to the engagement member 43. Additionally or alternatively, an electrostatic force may be applied to engage the die 51 with the engagement member 43.

As shown in Figure 3, in an embodiment the engagement member 43 is at substantially the opposite end of the transfer arm 40 from the pivot 45. The path that the engagement member 43 follows during use of the die supplier 10 may correspond to the stroke 46 of the transfer arm 40.

When the transfer arm 40 is located such that the engagement member 43 is directly above the centre of a die 51 supported on the donor substrate 50, the controller may control the engagement member 43 to engage with the die 51. Engaging with the die 51 may comprise picking up the die 51. The transfer arm 40 may then be moved (e.g. rotated) so that the engagement member 43 would be engaged die 51 is moved to the stage 20. In an embodiment the controller is configured to disengage the die 51 from the engagement member 43 (e.g. by reducing an engagement course) so as to deposit the die 51 onto the stage 20.

As shown in Figure 3, in an embodiment the transfer arm 40 is actuatable substantially perpendicularly to the donor substrate 50. For example, as shown in Figure 3 in an embodiment the transfer arm 40 is configured for vertical motion along a translational axis 42. In an embodiment the translational axis 42 is substantially coaxial with the transfer axis 41 of the rotational motion of the transfer arm 40. Providing that the transfer arm 40 is capable of making vertical motions, the transfer arm 40 may readily be able to pick and place the dies 51.

However, it is not essential for the transfer arm 40 to be actuatable substantially perpendicularly to the donor substrate 50. For example, in an alternative embodiment the donor support 30 may be configured to make vertical motions in order to allow a die 51 to be picked by the transfer arm 40. In an embodiment the stage 20 is configured to be actuatable vertically so as to allow a die 51 to be placed by the transfer arm 40 onto the stage 20.

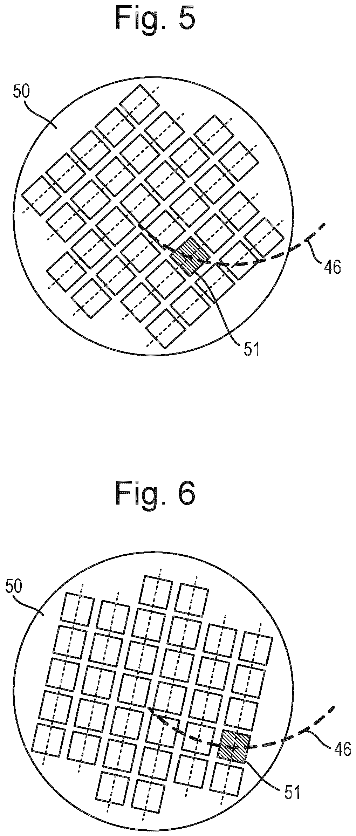

Figure 4 is a plan view of the donor substrate 50 supporting dies 51. In the orientation shown in Figure 4, the donor substrate 50 is at a first rotational position. Figure 5 is a plan view of the same donor substrate 50 at a second rotational position. The second rotational position is different from the first rotational position. Figure 6 is a plan view of the same donor substrate 50 at a third rotational position. The third rotational position is different from the first rotational position. The third rotational position is different from the second rotational position.

The rotation of the donor support 30 about the rotational axis 31, the dies 51 will be picked up under varying angles (i.e. with the donor substrate 50 at different rotational positions). For example, Figure 5 shows one die 51 to be picked up while the donor substrate 50 is at the second rotational position. Figure 6 highlights a different die 51 to be picked up while the donor substrate 50 is at the third rotational position.

It is possible that there may be some rotational positions of the donor substrate 50 at which substantially no die 51 can be picked by the transfer arm 40. For example, in the rotational position shown in Figure 4, no die 51 can be picked. This is because none of the dies 51 has its centre on the stroke 46 of the transfer arm 40. The stroke 46 shown in Figure 4, Figure 5 and Figure 6 corresponds to the path traced by the engagement member 43 of the transfer arm 40 during use of the die supplier 10.

In an embodiment the controller is configured to control rotation of the donor support 30 such that the transfer arm 40 can engage with a die 51 to be transferred substantially at a centre of an exposed surface of the die 51. By engaging the centre of a die 51 with the engagement member 43, the die 51 can be transferred stably to the stage 20. The possibility of a die 51 undesirably dropping from the transfer arm 40 may be reduced.

In an embodiment the different required rotational positions of the donor support 30 in order to allow the different dies 51 to be picked by the transfer arm 40 may be determined in advance of a transfer operation. The transfer operation may be optimised so as to minimise the time required for all of the dies 51 to be transferred from the donor substrate 50.

As shown in Figure 3, in an embodiment the engagement member 43 is rotatable. For example, the engagement member 43 may be rotatable about a rotational axis 44. In an embodiment the engagement member 43 is rotatable such that a die 51 engaged by the engagement member 43 is rotatable. As shown in Figure 3, in an embodiment the rotational axis 44 of the engagement member 43 is substantially parallel to the rotational axis 31 of the donor support 30 and/or the translational axis 42 of the transfer arm 40 and/or the transfer axis 41 for rotational movement of the transfer arm 40. In an embodiment the controller is configured to control rotation of the engagement member 43 so as to be able to always place the dies 51 on the stage 20 under substantially the same angle.

However, it is not essential for the engagement member 43 to be rotatable such that a die 51 engaged by the engagement member 43 is rotatable. For example, in an alternative embodiment the stage 20 is rotatable such that an angular offset of the die 51 may be compensated for. In an alternative embodiment, the engagement member 43 of the transfer arm 40 is rotatable and additionally the stage 20 is rotatable about a parallel axis. In an embodiment the rotational stroke of the stage 20 is more limited than the rotational stroke of the engagement member 43. The stage 20 may be configured to rotate so as to compensate for smaller angular offsets of the die 51. This may reduce the accuracy with which the rotational position of the engagement member 43 is required to be controlled.

In an embodiment the controller is configured to control the donor support 30 to rotate during time periods between the transfer arm 40 transferring sequential dies 51 from the donor substrate 50. In an embodiment a transfer operation comprises transferring a sequence of dies 51 from the donor substrate 50. For example, a first die, a second die, a third die etc may be transferred from the same donor substrate 50. During use of the die supplier 10, the donor support 30 rotates the donor substrate 50 in between transferring sequential dies 51, for example between transferring the first die and the second die, and between transferring the second die and the third die. Additionally, the donor support 30 may rotate the donor substrate 50 before and after the transfer operation.

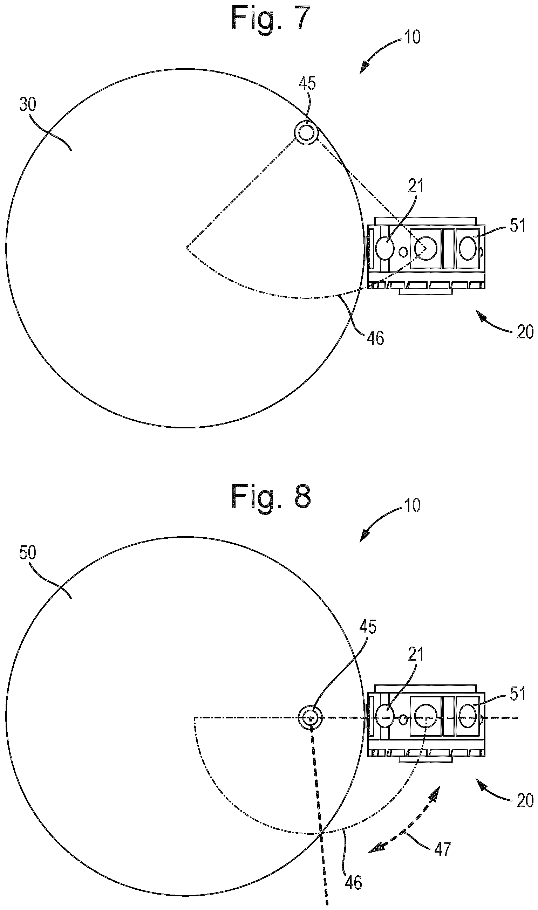

Figure 7 schematically depicts a plan view of the die supplier 10 shown in Figure 3. As can be seen in Figure 7, in an embodiment the maximum rotational stroke of the transfer arm 40 is 90°. However, it is not essential for the rotational stroke of the transfer arm 40 to be limited to 90°. Figure 8 is a plan view schematically depicting an alternative die supplier 10. In the arrangement shown in Figure 8, the rotational stroke of the transfer arm 40 is about 180°. That is, the transfer arm 40 makes a maximum stroke of 180° back and forth.

By increasing the rotational stroke, the length of the transfer arm 40 may be reduced. By reducing the length of the transfer arm 40, inertia may be reduced. By reducing inertia, it may be easier to accelerate and decelerate the transfer arm 40.

In an embodiment, the maximum stroke 46 and the length of the transfer arm 40 are selected so as to maximise throughput of transferring dies 51 from the donor substrate 50.

Figure 8 schematically shows the minimum angle 47 of the rotation of the transfer arm 40 in order to pick a die 51 located near the edge (i.e. the periphery) of the donor substrate 50. In the arrangement shown in Figure 8, dies 51 that are placed near the edge of the donor substrate 50 have a greater minimum angle 47 compared to the configuration shown in Figure 7, for example, in an embodiment, the length of arm of the transfer arm 40 and the stroke 46 are selected so as to optimise timing, inertia, duty cycle and/or heat dissipation.

During use of the die supplier 10, a motor of the transfer arm 40 may heat up. In order to dissipate heat, it can help to first pick a die 51 close to the centre (with a large stroke of the transfer arm 40) and after that pick a die 51 close to the edge of the donor substrate 50 (with a small stroke of the transfer arm). This may allow the motor of the transfer arm 40 to cool down in the idle time. This sequence may then be repeated.

For example, in an embodiment the controller is configured to control the transfer arm 40 to alternately transfer dies that are closer to a centre of the donor substrate 50 and dies 51 that are closer to a periphery of the donor substrate 50.

However, it is not essential for the transfer arm 40 to alternately pick dies close to the edge of the wafer and dies close to the centre. In an alternative arrangement, the order in which dies 51 are picked from the donor substrate 50 is determined so as to optimise timing, inertia or duty cycle, for example.

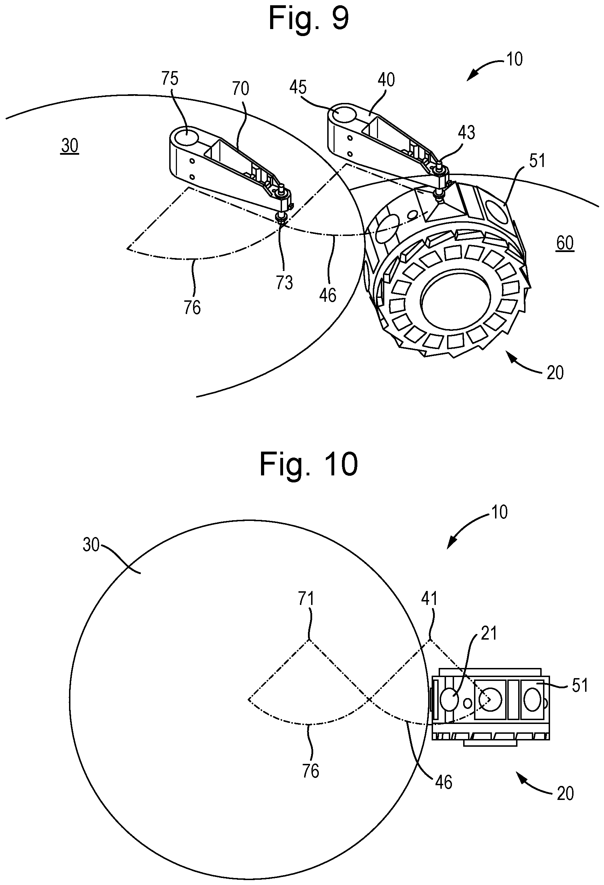

Figure 9 schematically depicts a perspective view of an alternative die supplier 10. Features that are the same as the features of the die supplier 10 described elsewhere, for example in relation to Figure 3, Figure 7 or Figure 8, are not described again in detail. Figure 10 is a schematic plan view of the die supplier 10 shown in Figure 9.

As shown in Figure 9, in an embodiment the die supplier 10 comprises an intermediate arm 70. The intermediate arm 70 is configured to transfer dies 51 from closer to a centre of the donor substrate 50 to closer to a periphery of the donor substrate 50. In an embodiment the intermediate arm 70 is configured to move between different locations of the substrate 50. The intermediate arm 70 may not be required to reach beyond the donor substrate 50 because the intermediate arm 70 may not in use dies 51 away from the donor substrate 50.

In an embodiment the transfer arm 70 has mechanical features and functionality substantially the same as the transfer arm 40. For example, as shown in Figure 9 the intermediate arm 70 may comprise a pivot 75 and an engagement member 73 at opposite ends of the intermediate arm 70. The engagement member 73 may trace a path corresponding to the stroke 76 of the intermediate arm 70 during use of the die supplier 10. The intermediate arm 70 may be configured to rotate the pivot 75 about a rotational axis substantially parallel to the transfer axis 41 of the transfer arm 40.

An embodiment of the invention is expected to increase the speed of transfer. By providing the intermediate arm 70, the length of the transfer arm 40 may be reduced. By reducing the length of the transfer arm 40, the inertia may be reduced, thereby increasing the speed of the transfer. As shown in Figure 9, in an embodiment the length of the transfer arm 40 is reduced such that the transfer arm 40 cannot reach all of the dies 51 on the donor substrate 50. For example, in an embodiment the transfer arm 40 is configured such that the centre of the donor substrate 50 is beyond its stroke 46.

By providing the intermediate arm 70, which may be substantially similar to the transfer arm 40 in structure and functionality, substantially all of the dies 51 on the donor substrate 50 may be picked in an embodiment the intermediate arm 70 moves simultaneously with the transfer arm 40. In an embodiment the controller is configured to control motion of the intermediate arm 70.

In use, the intermediate arm 70 may be configured to pick a die 51 from near the centre of the donor substrate 50 and place it near the edge of the donor substrate 50 on an empty spot. An empty spot means that there is not another die 51 that is to be picked later in that position. It is not essential that the intermediate arm 70 places a die 51 right at the edge of the donor substrate 50. The intermediate arm 70 places dies 51 within the reach of the transfer arm 40. For example, the intermediate arm 70 may be configured to place a die 51 in a location from which the transfer arm 40 has previously transferred a die 51.

The transfer arm 40 is configured to pick a die 51 near the edge of the donor substrate 50 and place it on the stage 20. For example, the stage 20 may comprise a plurality of die acceptors 21. The transfer arm 40 may be configured to place a die 41 onto a die acceptor 21 of the stage 20.

In an embodiment the intermediate arm 70 is configured to place a die 51 on an intermediate parking station just above the donor substrate 50.

In an embodiment the engagement member 43 of the transfer arm 40 is configured to rotate so as to rotate the die 51 engaged by the engagement member 43. It may not be necessary for the engagement member 73 of the intermediate arm 70 to be rotatable. Alternatively, the engagement member 73 of the intermediate arm 70 may be configured to rotate. The rotational function of the engagement member 43 of the transfer arm 40 may then be omitted.

In an embodiment the controller is configured to control the intermediate arm 70 and the transfer arm 40 so as to avoid collisions between the intermediate arm 70 and the transfer arm 40.

Figure 11 schematically depicts an alternative die supplier 10. Figure 11 depicts a plan view of the die supplier 10. Features of the die supplier 10 that are the same as the features described elsewhere, for example with reference to Figure 3, Figure 7, Figure 8, or Figure 9, are not repeated in detail.

As shown in Figure 11, in an embodiment the die supplier 10 comprises an additional transfer arm 40. That is, the die supplier 10 comprises a plurality of transfer arms 40a, 40b. The additional transfer arm 40b is configured to transfer dies 51 from the donor substrate 50. In an embodiment both transfer arms 40a, 40b are configured to transfer dies 51 to substantially the same location away from the donor substrate 50. For example, as shown in Figure 11, in an embodiment both transfer arms 40a, 40b are configured to transfer dies 51 from the donor substrate 50 to the stage 20. In particular, dies 51 may be transferred to die acceptors 21 of the stage 20. The die acceptors 21 that receive the dies 51 may be positioned in substantially the same location in order to receive a die 51.

An embodiment of the invention is expected to increase throughput of transferring dies 51 from the donor substrate 50. For example, while one transfer arm 40a is placing a die 51 on the stage 20, the other additional transfer arm 40b may be moving so as to pick up a subsequent die 51. This may increase the frequency of transferring dies 51 away from the donor substrate 50.

By providing a plurality of transfer arms 40a, 40b, the complete surface of the donor substrate 50 can be addressed. That is, the complete surface can be reached by the transfer arms 40a, 40b.

It is not essential for each of the two transfer arms 40a, 40b to be able to reach all of the dies 51 on the rotating donor substrate 50. For example, in the arrangement shown in Figure 11, the transfer arm 40a can reach the centre of the donor substrate 50. However, the additional transfer arm 40b may be arranged such that the centre of the donor substrate 50 is beyond its stroke 46b. The stroke 46a of the transfer arm 40a may have the centre of the donor substrate 50 within it. The centre of the donor substrate 50 may be within the stroke of any one of the two transfer arms 40a, 40b.

As shown in Figure 11, in an embodiment the donor substrate 50 has a diameter 50d. Figure 11 depicts a circle 53 corresponding to part of the surface area of the donor substrate 50. In an embodiment the circle 53 has a diameter 53d such that the circle 53 has an area that is substantially equal to the area of the donor substrate 50 that is outside of the circle 53. The total surface area of the substrate 50 may be divided between the circle 53 and the outside area 52.

In an embodiment the controller is configured to control movement of the additional transfer arm 40b in addition to controlling motion of the transfer arm 40a and optionally also rotation of the donor substrate 50. In an embodiment the controller is configured to control the transfer arm 40a to pick a die from the area B and to control the additional transfer arm 40b to pick a die from the area C. Both the transfer arms 40a, 40b can address the same magnitude of area and so supply substantially the same number of dies 51. Of course, at the edge there may be fewer dies 51 present due to the rectangular shape of the dies 51. This may be affected by the size of the dies. The size of the circle may be selected so as to substantially equalise the number of dies 51 to be picked by the transfer arms 40a, 40b. The area B may be the area within the circle 53. Area C may correspond to the outside area 52 outside of the circle 53.

It is not essential for the additional transfer arm 40b to be provided. For example, the embodiment shown in Figure 3 has only a single transfer arm 40.

Referring to Figure 11, within area A, both transfer arms 40a, 40b can pick dies 51. By providing that the transfer arm 40a picks from the area B and the additional transfer arm 40b picks from the area C, the possibility of interference between the transfer arms 40a, 40b may be reduced. An embodiment of the invention is expected to reduce the possibility of damage to the die supplier 10.

In an embodiment the controller is configured to control the transfer arms 40a, 40b so as to avoid collisions between the transfer arms 40a, 40b. For example, the controller may be configured to control one of the transfer arms 40a, 40b to wait (remain stationary) while the other transfer arm 40b, 40a moves out of the way. In particular, it may be necessary to wait until the other transfer arm 40b, 40a has passed out of area A. The transfer arm 40a, 40b may then enter area A. The picking and placing sequence can be optimised so that the total transfer time is minimised.

In the arrangement shown in Figure 11, the die supplier 10 comprises two transfer arms 40a, 40b. In an alternative embodiment, more than two transfer arms 40 are provided. For example, the die supplier 10 may comprise three, four or more than four transfer arms.

Features that are described with reference to different drawings may be combined with each other unless it is apparent that those features are incompatible with each other. For example, the possibility of providing an additional transfer arm 40b as shown in Figure 11 may be combined with the feature of providing the intermediate arm 70 as shown in Figure 9 and Figure 10.

Figure 12 schematically depicts a cross-sectional view of a die supplier 10. The die supplier 10 may be the die supplier 10 shown in Figure 3 or Figure 7, for example. Figure 12 schematically shows a cross-sectional view of the donor support 30.

As shown in Figure 12, in an embodiment the donor support 30 comprises a motor 32. The motor 32 may be a rotary motor. The motor 32 may be configured to rotate the donor substrate 50.

As shown in Figure 12, in an embodiment the donor support 30 comprises an aperture 33. The aperture 33 may be substantially central relative to the rotational axis 31 of the donor support 30. In an embodiment the aperture 33 may be configured to accommodate a component for temporarily supporting the substrate 50 during an operation for loading donor substrate 50 onto the donor support 30 and/or unloading a donor substrate 50 from the donor support 30. For example, a pin may extend through the aperture 33 from below the donor support 30 so as to engage with and support the donor substrate 50.

As shown in Figure 12, in an embodiment the donor support 30 comprises one or more measurement sensors 34. The measurement sensors 34 may be configured to measure the rotational position of the donor support 30 and/or the donor substrate 50. It is not essential for a plurality of measurement sensors 34 to be provided. In an alternative arrangement, a single measurement sensor 34 is provided. By providing a plurality of measurement sensors 34, the measurements made by the measurement sensors 34 may be averaged. This may help to improve the accuracy of the measurements made by the measurement sensors 34. In an embodiment the measurement sensors 34 are configured to output data signals to the controller. The controller may be configured to control rotation of the donor support 30 dependent on data signals received from the measurement sensors 34.

As shown in Figure 12, in an embodiment the donor support 30 comprises a bearing 35. The bearing 35 may be a radial and axial bearing. In an embodiment the bearing 35 is a gas bearing. Alternatively, the bearing may be a magnetic levitated bearing or a mechanical roller (e.g. ball bearing). The bearing 35 is provided for rotation of the donor substrate 50.

By providing that the bearing 35 is a non-contact bearing (e.g. a gas bearing or a magnetic bearing), the possibility of particles being generated may be reduced.

In an embodiment the donor support 30 comprises a rotational feedthrough. The rotational feedthrough may be configured to provide a vacuum feedthrough and/or an electrical feedthrough, for example for providing the clamping force for clamping the donor substrate 50 onto the donor support 30. By providing a rotational feedthrough, cables and hoses may not be required towards the rotating world. In an embodiment the donor support 30 is configured to provide for the substantially infinite rotational stroke of the donor substrate 50. An embodiment of the invention is expected to reduce the possibility of damage to the donor support 30.

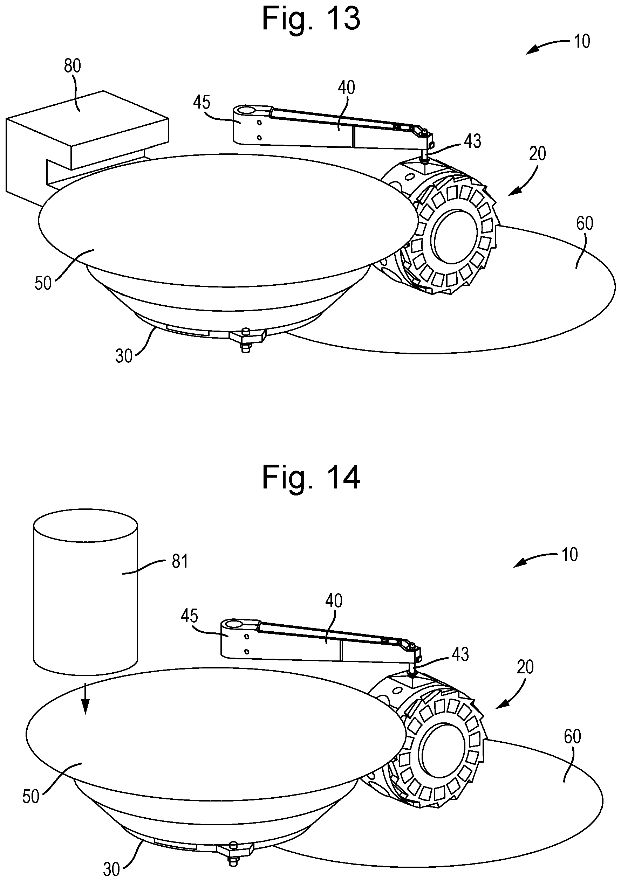

Figure 13 is a schematic perspective view of the die supplier 10. As shown in Figure 13, in an embodiment the die supplier 10 comprises a sensor 80. The sensor 80 is configured to detect a position of the donor substrate 50 supported by the donor support 30. The sensor 80 may be an edge sensor, as shown in Figure 13. The sensor 80 may be configured to determine the position and orientation of the donor substrate 50 after the donor substrate 50 has been loaded onto the donor support 30. In an embodiment the sensor 80 is configured to output a data signal to the controller. The data signal may be indicative of the position and orientation of the donor substrate 50 on the donor support 30. In an embodiment the controller is configured to control rotation of the donor support 30 and movement of the transfer arm 50 based partly on the data signal received from the sensor 80. In an embodiment the sensor 80 is configured to determine a location of one or more dies 51 from the donor substrate 50.

In an embodiment the lateral dimension of the donor substrate 50 is larger than the lateral dimension of the donor support 30. This may help the edge sensor to determine the center and orientation of the donor substrate 50 with respect to the donor support 30.

Figure 14 schematically depicts a perspective view of a die supplier 10. As shown in Figure 14, in an embodiment the die supplier 10 comprises a camera 81. The camera may be considered as a type of sensor. The camera may be located above the donor support 30. In an embodiment the camera 81 is configured to have a field of view downwards onto the upper surface of the donor substrate 50. In an embodiment the camera 81 is configured to determine the position and rotational orientation of the donor substrate 50 on the donor support 30. In an embodiment the camera 81 is configured to monitor positional drifts of the donor support 30. That is, during use of the die supplier 10 the translational position of the donor support 30 may vary. The camera 81 may be configured to measure any such drift. In an embodiment the sensor 80 (or camera 81) is fixed to a metrology frame that may be substantially isolated from the frame to which the donor support 30 and/or the transfer arm 50 is mounted. In an embodiment the camera 81 is configured to output a data signal to the controller. The data signal may be indicative of the position and rotational orientation of the donor substrate 50 on the donor support 30. The data signal may be indicative of positional drift of the donor support 30. In an embodiment the controller is configured to control rotation of the donor support 30 and motion of the transfer arm 40 based on a data signal received from the camera 81.

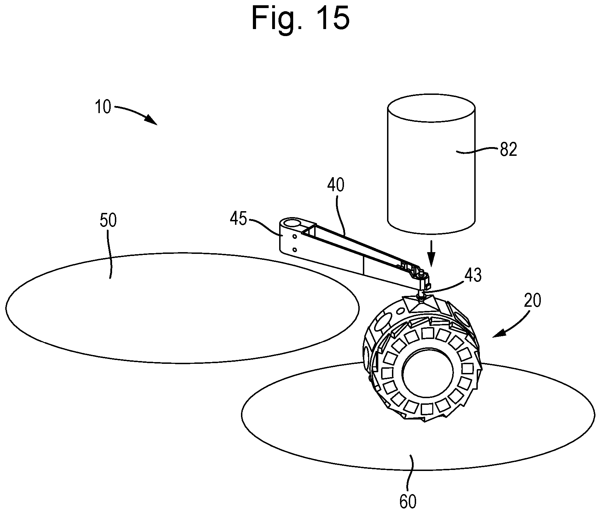

Figure 15 is a schematic perspective view of the die supplier 10. As shown in Figure 15, in an embodiment the die supplier 10 comprises a monitor 82. The monitor 82 may be configured to monitor placement of dies 51 at the location to which the transfer arm 40 transfers dies 51. For example, the transfer arm 40 may transfer arms 51 onto die acceptors 21 of the stage 20. The monitor 82 may be directed towards the die acceptors 21 of the stage 20. For example, the monitor 82 may be located above the stage 20. The monitor 82 may have a field of view including the stage 20, or at least a die acceptor 21 of the stage 20.

The monitor 82 may be located above the placement position on the stage 20. The monitor 82 may be, for example, a camera. The monitor 82 may be configured to monitor how the dies 51 are placed on top of the stage 20. The monitor 82 may be configured to output a data signal to the controller. The data signal may be indicative of the position of the dies 51 to be placed relative to the die acceptors 21 of the stage 20. In an embodiment the controller is configured to control the transfer arm 40 and/or the motion of the stage 20 based on the data signal received from the monitor 82. An embodiment of the invention is expected to at least partly compensate for low frequency drifts in the system.

Further embodiments of the invention are disclosed in the list of numbered clauses below:
1. A die supplier comprising:
   a donor support configured to support a donor substrate that supports a plurality of dies; and
   a transfer arm configured to transfer dies from the donor substrate;
   wherein the donor support is configured to rotate the donor substrate.
2. The die supplier of clause 1 comprising:
   a controller configured to control at least one of rotation of the donor support and movement of the transfer arm.
3. The die supplier of clause 2, wherein the controller is configured to control the donor support to rotate during time periods between the transfer arm transferring sequential dies from the donor substrate.
4. The die supplier of clause 2 or 3, wherein the controller is configured to control rotation of the donor support such that the transfer arm can engage with a die to be transferred substantially at a centre of an exposed surface of the die.
5. The die supplier of any of clauses 2-4, wherein the controller is configured to control the transfer arm to alternately transfer dies that are closer to a centre of the donor substrate and dies that are closer to a periphery of the donor substrate.
6. The die supplier of any preceding clause, wherein the transfer arm has a maximum lateral stroke less than or equal to a lateral dimension of the donor substrate.
7. The die supplier of any preceding clause, wherein the transfer arm is configured to rotate about a transfer axis.
8. The die supplier of clause 7, wherein the transfer arm has a maximum rotational stroke of at most 180°, and optionally at most 90°.
9. The die supplier of any preceding clause, wherein the transfer arm has a lateral dimension less than or equal to a lateral dimension of the donor substrate, and optionally less than half the lateral dimension of the donor substrate.
10. The die supplier of any preceding clause, wherein the transfer arm is actuatable substantially perpendicularly to the donor substrate.
11. The die supplier of any preceding clause, wherein the transfer arm comprises an engagement member configured to engage with a die so as to transfer the die from the donor substrate.
12. The die supplier of clause 11, wherein the engagement member is rotatable such that a die engaged by the engagement member is rotatable.
13. The die supplier of any preceding clause, comprising:
   an intermediate arm configured to transfer dies from closer to a centre of the donor substrate to closer to a periphery of the donor substrate.
14. The die supplier of clause 13, wherein the transfer arm is configured such that the centre of the donor substrate is beyond its stroke.
15. The die supplier of any preceding clause comprising:
   an additional transfer arm configured to transfer dies from the donor substrate, wherein both transfer arms are configured to transfer dies to substantially the same location away from the donor substrate.
16. The die supplier of clause 15, wherein a centre of the donor substrate is within a stroke of only one of the two transfer arms.
17. The die supplier of any preceding clause, wherein the donor support comprises at least one of a radial and axial gas bearing, a magnetic levitated bearing and a mechanical roller bearing for rotation of the donor substrate.
18. The die supplier of any preceding clause comprising:
   a sensor configured to detect a position of the donor substrate supported by the donor support.
19. The die supplier of any preceding clause comprising:
   a monitor configured to monitor placement of dies at the location to which the transfer arm transfers dies.
20. A bonding tool for bonding a die to an acceptor substrate, the bonding tool comprising the die supplier of any preceding clause.
21. A method for supplying dies comprising:
   supporting, with a donor support, a donor substrate that supports a plurality of dies; and
   transferring, with a transfer arm, dies from the donor substrate;
   wherein the donor support rotates the donor substrate.
22. A method of bonding a die to an acceptor substrate, the method comprising the method for supplying dies of clause 21.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A die supplier comprising:
a donor support configured to support a donor substrate that supports a plurality of dies; and
a transfer arm configured to transfer dies from the donor substrate;
wherein the donor support is configured to rotate the donor substrate.

2. The die supplier of claim 1 comprising:
a controller configured to control at least one of rotation of the donor support and movement of the transfer arm.

3. The die supplier of claim 2, wherein the controller is configured to control the donor support to rotate during time periods between the transfer arm transferring sequential dies from the donor substrate.

4. The die supplier of claim 2 or 3, wherein the controller is configured to control rotation of the donor support such that the transfer arm can engage with a die to be transferred substantially at a centre of an exposed surface of the die.

5. The die supplier of claim 2, wherein the controller is configured to control the transfer arm to alternately transfer dies that are closer to a centre of the donor substrate and dies that are closer to a periphery of the donor substrate.

6. The die supplier of claim 1, wherein the transfer arm has a maximum lateral stroke less than or equal to a lateral dimension of the donor substrate.

7. The die supplier of claim 1, wherein the transfer arm is configured to rotate about a transfer axis.

8. The die supplier of claim 7, wherein the transfer arm has a maximum rotational stroke of at most 180°, and optionally at most 90°.

9. The die supplier of claim 1, comprising:
an intermediate arm configured to transfer dies from closer to a centre of the donor substrate to closer to a periphery of the donor substrate.

10. The die supplier of claim 9, wherein the transfer arm is configured such that the centre of the donor substrate is beyond its stroke.

11. The die supplier of claim 1, further comprising:
an additional transfer arm configured to transfer dies from the donor substrate, wherein both transfer arms are configured to transfer dies to substantially the same location away from the donor substrate.

12. The die supplier of claim 11, wherein a centre of the donor substrate is within a stroke of only one of the two transfer arms.

13. The die supplier of claim 1, wherein the donor support comprises at least one of a radial and axial gas bearing, a magnetic levitated bearing and a mechanical roller bearing for rotation of the donor substrate.

14. A bonding tool for bonding a die to an acceptor substrate, the bonding tool comprising the die supplier of claim 1.

15. A method for supplying dies comprising:
supporting, with a donor support, a donor substrate that supports a plurality of dies; and
transferring, with a transfer arm, dies from the donor substrate;
wherein the donor support rotates the donor substrate.
